# FASCICULE DE BREVET EUROPEEN

(11) **EP 2 761 721 B1**
(45) Date de publication et mention de la délivrance du brevet: **21.11.2018**
(21) Numéro de dépôt: 12773075.2
(22) Date de dépôt: 25.09.2012
(51) Int. Cl.: H02J 13/00, G06F 1/26, H04L 12/12

(54) **DISPOSITIF DE COMMANDE D'UN INTERRUPTEUR D'ALIMENTATION ELECTRIQUE ET APPAREIL ELECTRIQUE ASSOCIE**
VORRICHTUNG ZUR STEUERUNG EINES STROMSCHALTERS UND ZUGEHÖRIGE ELEKTRISCHE ANWENDUNG
DEVICE FOR CONTROLLING A POWER SWITCH, AND RELATED ELECTRICAL APPLIANCE

(30) Priorité: 30.09.2011 FR 1158821
(43) Date de publication de la demande: 06.08.2014
(73) Titulaire: Orange, 75015 Paris (FR)
(72) Inventeur: PAGANI, Pascal, F-22200 Guingamp (FR)
(86) Numéro de dépôt international: PCT/FR2012/052140
(87) Numéro de publication internationale: WO 2013/045811

(56) Documents cités:
- FR-A1- 2 488 069
- GB-A- 1 009 052
- US-A- 2 231 174
- US-A- 3 558 902
- US-A1- 2009 271 013
- US-A1- 2009 322 159

## Description

### 1. Domaine de l'invention

Le domaine de l'invention est celui de l'alimentation en énergie des appareils électriques, tels que les équipements domestiques (téléviseurs, lave-linge, etc.) ou les équipements de communication (modem à Courant Porteur en Ligne (CPL), point d'accès WiFi, etc.). Plus précisément, l'invention concerne la commande à distance de la connexion/déconnexion de tels appareils à un réseau d'alimentation électrique.

### 2. Art antérieur et ses inconvénients

La consommation énergétique des équipements électriques, qu'il s'agisse d'équipements électroménagers ou d'équipements de communication, constitue une préoccupation croissante de leurs utilisateurs. En effet, les consommateurs sont de plus en plus sensibles au coût croissant de l'énergie, d'une part, et à l'impact environnemental de la production énergétique, d'autre part.

Les fabricants de ces équipements domestiques prennent donc tous en compte le paramètre de l'efficacité énergétique dans la conception de leurs appareils.

Ainsi, afin de réduire leur consommation énergétique, la plupart de ces appareils domestiques présentent désormais un mode de veille, dans lequel ils n'assurent plus leur fonction principale mais présentent une consommation électrique réduite.

Dans un tel mode de veille, l'appareil doit pouvoir passer très rapidement en mode actif, par une commande ou une action simple de l'utilisateur. Ainsi, par exemple, un téléviseur en mode de veille maintient son récepteur infrarouge actif, de façon à pouvoir basculer très rapidement en mode actif, lorsque l'utilisateur cherche à le rallumer par simple pression sur la télécommande associée.

De ce fait, même lorsqu'ils sont en mode de veille, la consommation électrique de ces équipements n'est pas nulle, ce qui constitue un inconvénient de cet art antérieur.

Cette consommation électrique résiduelle des équipements en mode de veille est également due au fait que la plupart de ces équipements sont reliés à l'alimentation électrique du secteur par l'intermédiaire d'un transformateur (généralement de courant alternatif en courant continu), qui consomme de l'énergie électrique, même lorsque les équipements sont en mode de veille.

La problématique du passage rapide d'un équipement électrique du mode de veille au mode actif s'avère encore plus complexe pour les équipements de transmission de données, intégrés dans des systèmes de type WiFi ou CPL par exemple. En effet, pour de tels équipements, le passage du mode de veille au mode actif, ou inversement, doit pouvoir être commandé à distance, par un équipement de contrôle du système de communication considéré.

Ainsi, un modem CPL par exemple bascule généralement en mode de veille à l'issue d'une période d'inactivité de durée prédéfinie; il doit cependant pouvoir sortir rapidement de ce mode de veille en réponse à une sollicitation du modem CPL coordinateur du réseau de communication. Pour répondre à cette problématique, le mode de veille des modem CPL est généralement fondé sur une réduction importante du cycle de vie (en anglais "duty cycle"): au lieu de communiquer en temps continu, le modem CPL n'est par exemple opérationnel que pendant 1% du temps, afin de pouvoir recevoir d'éventuels messages protocolaires demandant son réveil pendant cette courte période d'écoute. En conséquence, si la consommation électrique d'un modem CPL en mode de veille est fortement réduite, elle n'est pas nulle pour autant, ce qui constitue un inconvénient de cet état de l'art.

Afin de pallier à cet inconvénient, et de résoudre le double problème de la réduction de la consommation électrique des équipements et de la possibilité de les réactiver rapidement, y compris à distance, des systèmes ont été proposés qui permettent simultanément:
- de couper totalement l'alimentation électrique d'un équipement, en amont de son transformateur (afin d'éviter la consommation continue du transformateur évoquée ci-dessus);
- de permettre d'activer, à distance, la connexion ou la déconnexion de l'équipement à son alimentation électrique.

Ces systèmes sont constitués d'interrupteurs pouvant être commandés à distance par un signal de type infrarouge, radio ou GSM (pour "Global System for Mobile Communications", en français "Système mondial de communication mobile") par exemple, qui viennent s'interfacer entre l'équipement dont on souhaite contrôler la consommation électrique et l'alimentation électrique de ce dernier.

Ainsi, on peut citer à titre d'exemple le produit "GSM Mini" (marque déposée) commercialisé par la société EcoStarter (marque déposée), qui consiste en une prise 230V télécommandée par SMS. Ce dispositif comprend une fiche électrique mâle, qui peut être connectée au réseau d'alimentation électrique, et une fiche électrique femelle sur laquelle peut être branché l'équipement dont on souhaite réduire la consommation électrique, de sorte que ce dispositif vient s'interfacer entre la prise électrique d'alimentation du secteur et l'équipement à contrôler. Il comprend par ailleurs une carte SIM (pour "Subscriber Identity Module", en français "module d'identité d'utilisateur"), apte à recevoir un signal de commande de type SMS (pour "Short Message Service", en français "Service de messages courts"), pour actionner l'ouverture ou la fermeture du circuit d'alimentation électrique de l'équipement qui lui est connecté.

D'autres systèmes d'interrupteur similaires existent, dans lesquels le signal de commande n'est pas de type SMS, mais est par exemple de type infrarouge ou radio: le principe de fonctionnement est cependant similaire, à savoir que le signal de commande reçu permet d'ouvrir ou fermer le circuit d'alimentation électrique du dispositif dont on cherche à maîtriser la consommation énergétique.

Si ces systèmes de l'art antérieur présentent l'avantage de couper totalement l'alimentation électrique de l'équipement domestique ou de communication dont on cherche à réduire la consommation, ils présentent cependant tous l'inconvénient majeur de présenter une consommation électrique résiduelle non nulle. En effet, tous ces systèmes d'interrupteurs commandables à distance doivent pouvoir répondre dès réception d'un signal de commande (GSM, radio ou infrarouge par exemple), en ouvrant ou fermant le circuit d'alimentation électrique de l'équipement domestique ou de communication qu'ils contrôlent: pour ce faire, ils comprennent donc des moyens de traitement de ce signal de commande, qui sont la plupart du temps en mode de veille, mais présentent donc de ce fait une consommation électrique non nulle.

En outre, un autre inconvénient de ces systèmes de l'art antérieur est que les moyens de traitement du signal de commande qu'ils comprennent sont souvent complexes et, de ce fait, coûteux.

La demande de brevet américaine US 2009/0271013 présente ainsi un système de commande piloté à distance d'alimentation électrique d'équipements domestiques, par l'intermédiaire d'interrupteurs commandés par le biais d'un module de contrôle, lequel communique avec un serveur distant par l'intermédiaire d'un module de communication.

Dans un tel système, outre la complexité engendrée pour mettre en place la détection et la conversion des signaux de contrôle par le module de communication, le module de contrôle et du module de communication se retrouvent dans un état permanent de fonctionnement, aussi bien pour permettre la réception des signaux de contrôle provenant du serveur distant que l'envoi de signaux d'état de consommation des équipements vers ce serveur distant, ce qui engendre une consommation électrique importante.

La demande de brevet française FR2488069 présente de son côté un système de transmission de signaux dans lequel un organe est actionné à distance. Cependant, les moyens d'actionnement de cet organe, lesquels comportent notamment un démodulateur et un décodeur, engendrent une consommation électrique non négligeable nécessitant une alimentation électrique de ces moyens d'actionnement par l'intermédiaire du secteur ou d'une batterie autonome.

Le brevet US 2,231,174 décrit, pour sa part, un système de commande à distance de la fermeture d'un circuit de contrôle, dans lequel des signaux de commande peuvent être transmis sur un unique circuit d'alimentation électrique ordinaire, ce qui rend nécessaire la connexion à ce circuit d'alimentation électrique de tous les équipements souhaitant commander la fermeture du circuit de contrôle.

Il existe donc un besoin d'une technique de contrôle de l'alimentation électrique d'un appareil, commandable à distance, qui ne présente pas ces différents inconvénients de l'art antérieur. Notamment, il existe un besoin d'une telle technique qui soit simple et peu coûteuse à mettre en oeuvre, et qui présente une consommation électrique nulle.

### 3. Exposé de l'invention

L'invention répond à ce besoin en proposant un dispositif de commande selon la revendication 1. Des modes de réalisation avantageux sont définis par les revendications dépendantes.

Ainsi, l'invention repose sur une approche tout à fait nouvelle et inventive des dispositifs interrupteurs contrôlables à distance. En effet, l'invention propose un dispositif de commande d'un interrupteur d'alimentation électrique qui est totalement passif, de sorte qu'il présente une consommation électrique nulle, ce qui est particulièrement avantageux par rapport aux systèmes de l'art antérieur qui présentent tous une consommation électrique résiduelle non nulle.

En effet, l'invention propose une approche nouvelle et inventive des interrupteurs commandables à distance, selon laquelle l'énergie nécessaire à la réception du signal de commande et à l'ouverture ou la fermeture de l'interrupteur n'est pas fournie localement dans le dispositif de commande de l'interrupteur, mais est transmise par une entité distante, par le biais du signal de commande lui-même.

En outre, un tel dispositif étant totalement passif, il est très simple de conception, et de fabrication très peu coûteuse, ce qui n'est pas le cas des dispositifs connus dans l'art antérieur.

Grâce à un tel dispositif de commande d'interrupteur passif contrôlable à distance, l'invention permet ainsi de réduire à zéro la consommation énergétique d'un équipement domestique ou de communication lorsqu'il n'est pas en fonctionnement, tout en permettant sa réactivation rapide si besoin. Selon l'invention, de tels moyens de commande comprennent au moins un relais apte à actionner ledit au moins un interrupteur; un tel dispositif de commande comprend par ailleurs au moins un filtre passe-bande passif, apte à opérer un filtrage en fréquence du signal de commande, et qui est connecté audit au moins un relais.

Le ou les relais peuvent être de type statique ou électromécanique.

Un telle réalisation est de conception simple et peu coûteuse. L'ensemble filtre passe-bande et relais présente par ailleurs l'avantage d'être totalement passif. Le relais actionne l'ouverture ou la fermeture de l'interrupteur lorsque la tension à ses bornes est suffisante, cette tension étant extraite du signal de commande par l'intermédiaire du filtre passe-bande, comme exposé plus en détail en relation avec les figures.

Avantageusement, un tel dispositif de commande comprend au moins deux filtres passe-bandes dont les bandes passantes sont centrées sur des fréquences distinctes.

On fiabilise ainsi le fonctionnement du dispositif de l'invention, en évitant qu'un bruit, reçu sur le port d'entrée du dispositif, et contenu dans la bande de fréquence du filtre passe-bande passif, ne soit interprété à tort comme un signal de commande destiné à actionner l'interrupteur. En effet, pour actionner l'interrupteur, il convient désormais de recevoir, sur le port d'entrée du dispositif, un premier signal contenu dans la bande de fréquence du premier filtre passe-bande, et un second signal contenu dans la bande de fréquence du second filtre passe-bande. Seule la réception simultanée de ces deux signaux permet d'activer le relais, et ainsi d'actionner l'ouverture ou la fermeture de l'interrupteur.

Plus généralement, on peut envisager que le dispositif comprenne N filtres, où N est un entier supérieur ou égal à 2.

Selon une caractéristique avantageuse, un tel dispositif de commande comprend au moins deux relais, un premier relais apte à actionner l'ouverture de l'interrupteur et un deuxième relais apte à actionner la fermeture de l'interrupteur.

En effet, le dispositif de l'invention peut être conçu à partir d'un relais simple, i.e. un relais qui, actionné une première fois, provoque l'ouverture de l'interrupteur, puis qui, actionné une seconde fois, provoque la fermeture de l'interrupteur (ou inversement). Il peut également être conçu à partir d'un relais double, ou de deux relais, ce qui permet avantageusement de discriminer l'ouverture et la fermeture de l'interrupteur, et permet donc d'affiner sa commande.

Selon une variante de réalisation avantageuse, un tel dispositif de commande comprend au moins deux relais, un premier relais apte à actionner un premier interrupteur et un deuxième relais apte à actionner un deuxième interrupteur.

Dans cette variante de réalisation, les interrupteurs sont de préférence montés en série, et chaque relais est associé à un filtre passe-bande, de sorte que le circuit d'alimentation électrique de l'équipement dont on cherche à contrôler la consommation énergétique est fermé si, et seulement si, le signal reçu sur le port d'entrée comprend des composantes fréquentielles dans chacune des bandes de fréquence des différents filtres passe-bandes du dispositif.

On peut également envisager qu'un relais soit commandé par deux (ou plus) filtres passe-bandes. Dans ce cas, les deux (ou plus) filtres sont en parallèle, et le relais est actionné si la tension à ses bornes provenant de la sommes des deux (ou plus) filtres est suffisante. Selon l'invention, un tel dispositif de commande comprend également un port de commande connecté audit au moins un relais.

Ainsi, l'interrupteur peut être, soit commandé à distance par un signal de commande reçu sur le port d'entrée, soit commandé directement par une entité locale, apte à injecter la tension adéquate aux bornes du relais, par l'intermédiaire du port de commande. Cette dernière variante s'avère particulièrement avantageuse dans le cas où l'équipement dont on cherche à maîtriser la consommation énergétique est par exemple un équipement d'un réseau de communication. Dans ce cas, le passage de cet équipement en mode déconnecté peut résulter d'une négociation entre deux entités communicantes, en utilisant un protocole de communication propre au système de communication considéré. A l'issue de la négociation, la déconnexion de l'équipement peut être effectuée, soit par l'entité distante qui émet un signal de commande reçu sur le port d'entrée du dispositif de l'invention, soit par l'entité locale, par l'intermédiaire du port de commande de ce dispositif.

Dans un premier mode de réalisation avantageux, le port d'entrée est une prise électrique mâle, le dispositif de commande comprend une prise électrique femelle connectée à la prise électrique mâle par au moins un fil de phase et au moins un fil de neutre, et l'interrupteur est situé sur l'un des fils de phase reliant la prise électrique mâle et la prise électrique femelle.

Ainsi, l'équipement dont on cherche à contrôler la consommation énergétique est branché sur le dispositif de l'invention, qui est lui-même branché sur le réseau d'alimentation électrique. Dans ce cas, le signal de commande est de type CPL. En effet, le réseau électrique est particulièrement adapté pour transmettre un tel signal de commande, car il permet la réception d'un signal avec suffisamment de puissance pour actionner un relais de manière passive.

Dans un deuxième mode de réalisation avantageux, le port d'entrée est de type optique, et le filtre passe-bande est un filtre passe-bande optique passif.

Ce type de dispositif est particulièrement adapté pour contrôler l'alimentation électrique des équipements présents sur un réseau de communication optique.

Dans un troisième mode de réalisation avantageux, le signal de commande est un signal radio et le dispositif comprend une antenne apte à recevoir le signal radio et à le transmettre au port d'entrée.

Selon une variante avantageuse, ce dispositif comprend en outre un élément de stockage d'énergie inséré entre le port d'entrée et les moyens de commande, ce qui permet l'alimentation des moyens de commande et le basculement de l'interrupteur au moyen de signaux de commande à faible niveau énergétique tels que des signaux de commande optique ou radio.

L'invention concerne également un appareil électrique comprenant un dispositif de commande d'un interrupteur d'alimentation électrique tel que décrit précédemment.

En effet, le dispositif de l'invention peut se présenter sous forme d'un module indépendant, apte à être connecté à l'appareil électrique dont on veut contrôler la consommation électrique, ou être intégré directement dans cet appareil.

Avantageusement, un tel appareil est un modem à Courant Porteur en Ligne.

### 5. Liste des figures

L'invention est définie par les revendications annexées. Des modes ou variantes de réalisation qui ne seraient pas couverts par les revendications ne font pas partie de l'invention. D'autres avantages et caractéristiques apparaîtront plus clairement à la lecture de la description suivante d'un mode de réalisation particulier , donné à titre de simple exemple illustratif et non limitatif, et des dessins annexés, parmi lesquels :
- la figure 1 présente un premier exemple de dispositif de commande, sous forme d'un boîtier comprenant une prise électrique mâle et une prise électrique femelle;
- la figure 2 illustre une variante de réalisation du dispositif de la figure 1, dans laquelle ce dispositif présente un port de commande conformément à l'invention;
- les figures 3A et 3B présentent un deuxième exemple de dispositif de commande, qui diffère de celui de la figure 1 en ce qu'il comprend une antenne apte à recevoir un signal de commande de type radio;
- la figure 4 décrit un dispositif qui comprend une pluralité de filtres passe-bandes et de relais;
- la figure 5 présente un réseau domestique auquel sont connectés plusieurs équipements qui intègrent chacun un dispositif conforme à la figure 1.

### 6. Description d'un mode de réalisation particulier de l'invention

Le principe général de l'invention repose sur la conception d'un dispositif totalement passif, qui peut être commandé à distance, pour contrôler l'ouverture ou la fermeture d'un interrupteur du circuit d'alimentation électrique d'un équipement.

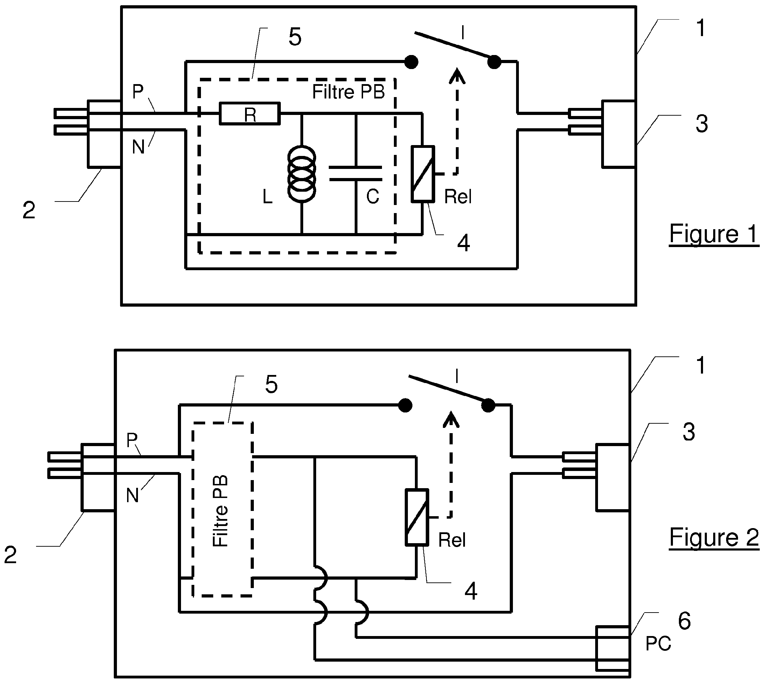

Le dispositif 1 se présente sous la forme d'un boîtier, comprenant une prise électrique mâle 2 et une prise électrique femelle 3, ainsi que des moyens de commande 4,5 d'un interrupteur I, lesquels comprennent un relais Rel 4 et un filtre passe-bande 5 dans l'exemple illustré sur la figure 1.

La prise de courant mâle 2 est connectée à la prise de courant femelle 3 par l'intermédiaire de fils de phase P et de neutre N. Par souci de simplification, on n'a pas représenté sur la figure 1 la possible connexion directe du fil de terre entre les prises mâle 2 et femelle 3. Le fil de phase P est muni d'un interrupteur I commandé à l'aide des moyens de commande susmentionnés.

La fiche électrique mâle 2 est destinée à être connectée sur une prise électrique femelle d'un réseau d'alimentation électrique (par exemple un réseau électrique domestique), et la fiche électrique femelle 3 est destinée à recevoir une fiche électrique mâle d'un équipement dont on cherche à réduire la consommation électrique hors fonctionnement (par exemple un téléviseur ou un modem CPL).

Les moyens de commande 4,5 de l'interrupteur I sont électriquement passifs en l'absence de signal de commande, i.e. ils n'ont pas besoin de consommer d'énergie électrique pour se maintenir dans un état de repos dans lequel ils sont inactifs et n'agissent pas sur l'interrupteur I.

La consommation électrique de ces moyens de commande peut ainsi être considérée comme étant sensiblement nulle en l'absence de signal de commande, en faisant abstraction des éventuels courants de fuites involontaires qui induisent une consommation électrique négligeable.

Ces moyens de commandes sont configurés pour être alimentés électriquement au moyen d'un signal de commande, lequel fournit alors intrinsèquement l'énergie nécessaire à ces moyens de commande pour ouvrir ou fermer l'interrupteur I, sans que ces moyens de commande n'aient besoin d'être alimentés électriquement par d'autres moyens que ce signal de commande. En d'autres termes, ces moyens de commande peuvent fonctionner sans être alimentés électriquement par le réseau électrique.

Ainsi, pour reprendre le mode de réalisation illustré à la figure 1, lorsqu'une tension V est présente aux bornes du relais Rel 4, ce dernier actionne l'interrupteur I, pour l'ouvrir ou le fermer. En effet, sur la figure 1, le relais Rel 4 représenté est un relais simple, i.e. que des actions successives du relais conduisent à l'ouverture, puis à la fermeture de l'interrupteur.

Dans une variante de réalisation du dispositif 1, le relais Rel 4 pourrait être remplacé par un double relais, ou par tout autre dispositif passif permettant de discriminer l'ouverture et la fermeture de l'interrupteur I.

Le relais Rel 4 est alimenté par les fils de phase P et de neutre N par l'intermédiaire d'un filtre passe-bande 5. Un tel filtre 5 est de préférence sélectif en fréquence, et filtre tout signal situé en dehors d'une bande fréquentielle centrée sur une fréquence F0. Ce filtre 5 étant passif, le dispositif 1 ne présente pas de consommation électrique en fonctionnement nominal, i.e. lorsqu'aucun signal électrique n'est présent dans la bande fréquentielle centrée sur F0 aux bornes du filtre 5.

Dans l'exemple de la figure 1, le filtre passe-bande 5 comprend une résistance R, une inductance L et une capacité C. L'exemple concerne bien sûr également un dispositif tel que représenté sur la figure 1, dans lequel le filtre passe-bande 5 serait remplacé par tout autre dispositif de filtre passif produisant le même effet.

En mode déconnecté, l'interrupteur I est ouvert, et l'appareil connecté du côté de la prise femelle 3 n'est pas alimenté. Lorsqu'un signal, présentant une composante fréquentielle comprise dans la bande de fréquence du filtre passe-bande 5, est reçu sur le port d'entrée constitué par la prise électrique mâle 2, il constitue un signal de commande: en sortie du filtre passe-bande 5, la tension aux bornes du relais Rel 4 passe à une valeur V, et le relais Rel 4 actionne donc la fermeture de l'interrupteur I.

Un tel signal de commande est par exemple transmis sur le réseau électrique par un équipement distant, de façon à réactiver le fonctionnement de l'appareil connecté du côté de la prise femelle 3. Un tel équipement distant est par exemple un module de commande apte à émettre le signal de commande adéquat pour la fermeture de l'interrupteur I à distance.

A réception de ce signal de commande, l'appareil branché sur le dispositif 1 sort d'un mode déconnecté, et se met en route comme s'il venait d'être branché sur le secteur. L'exemple trouve notamment application dans le cas où le dispositif 1 est directement intégré dans un modem CPL, et où l'on considère un réseau de communication comprenant une pluralité de modems CPL munis chacun d'un interrupteur de déconnexion 1 intégré. Dans ce cas, on utilise des signaux de commande de fréquences distinctes pour piloter chaque dispositif 1 de déconnexion de chacun des modems du réseau. De cette manière, un modem coordinateur du réseau peut décider de déconnecter chacun des modems du réseau, à l'issue d'un temps d'inactivité prédéterminé par exemple. Il conserve une table des modems qu'il peut atteindre, mais en mode déconnecté. De cette façon, lorsqu'une transmission est destinée à un modem du réseau qui se trouve en mode déconnecté, le module coordinateur émet le signal de commande approprié, afin de remettre le modem destinataire en mode connecté.

Dans le mode de réalisation décrit ci-dessus en relation avec la figure 1, la commande d'ouverture ou de fermeture de l'interrupteur I est transmise à distance par un module de commande qui n'a pas été illustré, par souci de simplification.

Cette commande peut également être transmise par un équipement local, connecté au dispositif 1, comme illustré sur la figure 2. Selon l'invention, le dispositif 1 comprend un port de commande PC référencé 6, sur lequel un équipement local, qui n'a pas été représenté par souci de simplification, peut injecter directement la tension V adéquate aux bornes du relais Rel 4.

En effet, le passage de l'équipement dont on cherche à maîtriser la consommation énergétique en mode déconnecté peut résulter d'une négociation entre deux entités communicantes d'un réseau de communication, à savoir une entité locale et une entité distante. Cette variante trouve notamment application dans le cas où l'équipement dont on cherche à maîtriser la consommation énergétique est un modem de communication, par exemple de type CPL: l'entité distante est alors le modem coordinateur du réseau, et l'entité locale est un autre équipement du réseau domestique, comme la passerelle résidentielle par exemple. L'invention est particulièrement avantageuse dans le cas d'un réseau de communication (par exemple dans un cadre domestique) comprenant une passerelle de communication connectée par câble Ethernet à un premier modem CPL, capable de communiquer avec un second modem CPL connecté à un PC par câble Ethernet. En l'absence de trafic sur le réseau, les deux modems CPL se mettent en veille. La passerelle résidentielle reste éveillée pour recevoir des données en provenance du réseau d'accès. Lorsqu'elle doit envoyer des données au PC, elle réveille le premier modem CPL via le port de commande du dispositif de commande qui lui est connecté ou intégré, puis le premier modem CPL (ou la passerelle) réveille le second modem CPL via la ligne électrique: la transmission de données entre ces différents équipements peut alors démarrer.

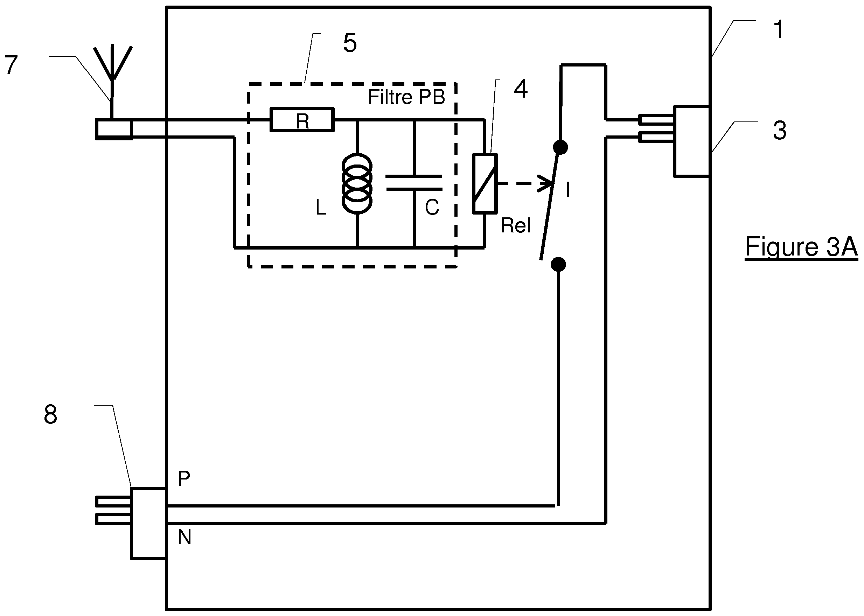

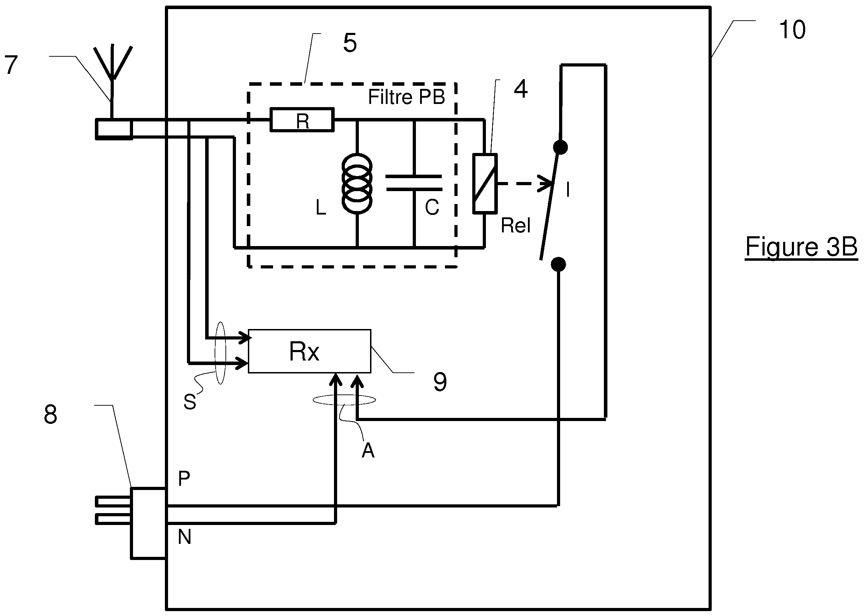

On décrit désormais en relation avec les figures 3A et 3B, une variante de réalisation du dispositif de la figure 1, dans laquelle le signal de commande est transmis au dispositif sous la forme d'un signal électromagnétique, reçu sur une antenne 7.

Dans l'exemple de la figure 3A, l'antenne passive 7 constitue le port d'entrée du dispositif 1, sur lequel est reçu le signal de commande. Un filtre passe-bande PB 5 filtre les composantes du signal de commande reçu sur l'antenne, de façon à ne laisser passer que les composantes fréquentielles comprises dans une bande passante centrée sur une fréquence F0. Si de telles composantes fréquentielles sont comprises dans le signal reçu sur l'antenne 7, on obtient en sortie du filtre PB 5 une tension V aux bornes du relais Rel 4, de sorte que ce dernier vient actionner l'interrupteur I. Si le dispositif 1 est relié au secteur par l'intermédiaire de la fiche électrique mâle 8, et à l'équipement dont on cherche à contrôler la consommation énergétique par l'intermédiaire de la fiche électrique femelle 3, l'ouverture de l'interrupteur I permet d'interrompre l'alimentation électrique de cet équipement, et ainsi de le faire passer en mode déconnecté.

Dans l'exemple illustré par la figure 3B, le dispositif de commande est intégré dans un système de communication radio 10, dont on cherche à réduire la consommation énergétique hors fonctionnement. Un tel système 10 comporte un récepteur radio Rx 9, destiné à recevoir ou émettre un signal de communication. L'antenne 7, constituant le port d'entrée du dispositif de commande, est reliée à ce récepteur radio Rx 9, auquel elle fournit le signal de commande S.

Le récepteur radio Rx 9 est relié au réseau d'alimentation électrique grâce à la prise électrique mâle 8. Conformément à l'invention, son alimentation en énergie (A) est commandable, en fonction de l'état ouvert ou fermé de l'interrupteur I.

Sur la figure 3, le filtre passe-bande est un filtre passif de type RLC, comprenant une résistance R, une inductance L et une capacité C. Comme pour les dispositifs des figures 1 et 2, le dispositif de la figure 3 peut également être modifié pour intégrer tout autre type de filtre passe-bande passif.

A titre de variante, on peut également envisager que le dispositif 1 de la figure 3 ne comprenne pas de fiche électrique mâle 8, mais que l'interrupteur I soit situé sur un circuit d'alimentation électrique interne reliant l'équipement dont on cherche à réduire la consommation énergétique à une batterie.

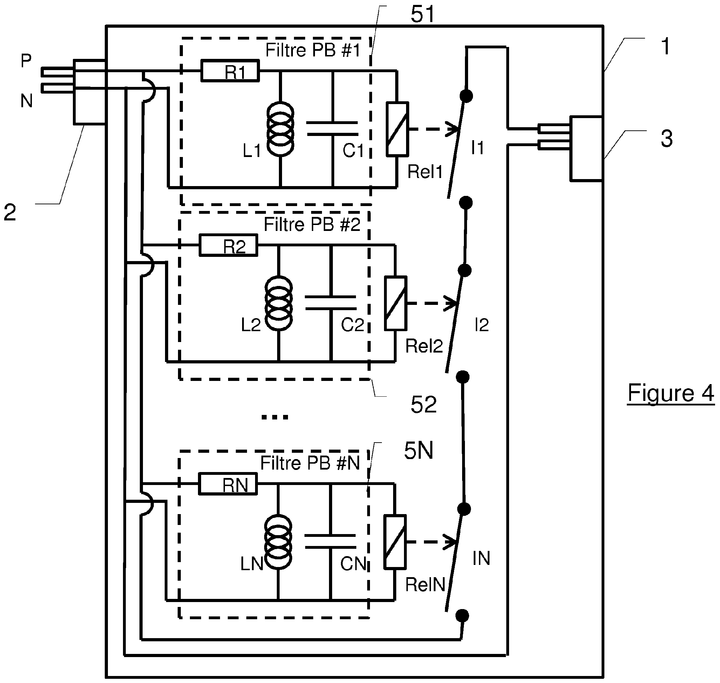

Les figures 1 et 3 illustrent deux modes de réalisation, l'un dans lequel le signal de commande est transmis par un réseau électrique, et l'autre dans lequel le signal de commande est transmis sous forme d'ondes électromagnétiques. On pourrait également envisager un mode de réalisation, non illustré, dans lequel le signal de commande serait transmis sous forme optique. Dans ce cas, le dispositif 1 présenterait un port d'entrée apte à recevoir un signal de commande transmis par fibre optique: le dispositif 1 comprendrait alors un filtre passe-bande optique apte à filtrer le signal optique reçu, disposé en amont d'un relais, conformément aux figures 1 et 4.

On présente désormais, en relation avec la figure 4, une variante de réalisation du dispositif 1 de la figure 1, dans laquelle le dispositif 1 comprend une pluralité de filtres passe-bandes et de relais.

Comme sur la figure 1, le dispositif 1 comprend une prise électrique mâle 2 formant le port d'entrée du dispositif, apte à recevoir un signal de commande en provenance d'un module de commande distant.

La prise de courant mâle 2 est connectée à une prise de courant femelle 3 par l'intermédiaire de fils de phase P et de neutre N. Par souci de simplification, on n'a pas représenté le fil de terre susceptible de relier les prises mâle 2 et femelle 3.

La prise électrique mâle 2 peut être branchée sur un réseau d'alimentation électrique domestique par exemple; la prise électrique femelle 3 peut quant à elle recevoir un équipement électrique dont on souhaite, selon l'invention, pouvoir commander le passage d'un mode connecté à un mode déconnecté, et inversement, à distance.

Le fil de phase P est muni d'une pluralité d'interrupteurs référencés I1, I2 à IN, montés en série. Chacun de ces interrupteurs I1 à IN est commandé à l'aide d'un relais référencé ReI1 à ReIN. Chacun de ces relais ReI1 à ReIN est disposé en sortie d'un filtre passe-bande passif 51 à 5N (Filtre PB#1 à Filtre PB#N). Sur la figure 4, chacun des ces filtres passe-bande passifs présente une architecture simple de type RLC, comprenant une résistance R1 à RN, une inductance L1 à LN, et une capacité C1 à CN.

De manière préférentielle, chacun de ces filtres 51 à 5N présente une bande-passante centrée sur une fréquence centrale distincte, de sorte qu'une composante fréquentielle distincte sert à piloter chacun des relais ReI1 à ReIN. En d'autres termes, l'équipement électrique connecté à la prise électrique femelle 3 n'est alimenté que lorsque le signal de commande reçu sur le port d'entrée constitué par la prise électrique mâle 2 comprend les N composantes fréquentielles comprises dans les N bandes passantes des N filtres 51 à 5N.

Sur la figure 4, tous les interrupteurs I1 à IN sont dans l'état ouvert à l'état initial, et passent dans l'état fermé, suite à la réception d'un signal de commande adéquat sur la prise électrique mâle. A titre de variante, certains interrupteurs peuvent être dans l'état fermé à l'état initial, tandis que d'autres sont dans l'état ouvert. Ainsi, dans un exemple de dispositif 1 comprenant trois interrupteurs I1, I2 et I3, on peut imaginer que les interrupteurs I1 et I2 sont initialement dans un état ouvert, et que l'interrupteur I3 est initialement dans un état fermé. Le circuit d'alimentation électrique reliant les prises électriques mâle 2 et femelle 3 ne passe donc dans l'état fermé que si le signal de commande reçu sur la prise électrique mâle 2 comprend des composantes fréquentielles aux fréquences F1 et F2 (à savoir les fréquences centrales des bandes passantes des filtres passe-bandes 51 et 52) mais ne comprend pas de composante fréquentielle à la fréquence F3 (à savoir la fréquence centrale de la bande passante du filtre passe-bande 53).

Dans une autre variante de réalisation du dispositif 1 de la figure 4, l'un (ou plusieurs) des relais ReI1 à ReIN n'est pas commandé par un mais par deux (ou plus) filtres passe-bandes. Dans ce cas, les deux (ou plus) filtres passe-bandes sont montés en parallèle, et le relais qu'ils commandent actionne l'interrupteur associé lorsque la tension à ses bornes, provenant de la somme des deux (ou plus) filtres est suffisante.

On a présenté, en relation avec les figures 1 à 4, un premier mode de réalisation dans lequel le dispositif de commande de l'interrupteur conforme à l'invention est conçu à partir d'un filtre passe-bande et d'un relais, alimenté en énergie par le signal de commande de l'interrupteur, reçu sur le port d'entrée depuis une entité distante.

On notera que d'autres modes de réalisation sont envisageables. Ainsi, les moyens pour actionner l'interrupteur peuvent se présenter sous la forme d'une commande électronique, alimentée à partir d'un élément de stockage d'énergie, tel qu'une pile, un accumulateur ou une batterie. La commande électronique n'actionne l'ouverture ou la fermeture de l'interrupteur que lorsque l'élément de stockage d'énergie présente un niveau de charge supérieur à un seuil prédéterminé. Par ailleurs, la charge de l'élément de stockage d'énergie débute lorsque la tension à ses bornes est suffisante. Cette tension est fournie par un équipement distant, sous la forme du signal de commande reçu sur le port d'entrée du dispositif.

Ce mode de réalisation est particulièrement avantageux lorsque le signal de commande présente des niveaux d'énergie relativement faibles, comme cela peut être le cas d'un signal de commande optique ou radio. Il peut ainsi être avantageux d'insérer un tel élément de stockage d'énergie entre le port d'entrée qui reçoit le signal de commande et les moyens de commande de l'interrupteur I, afin de permettre le basculement de l'interrupteur I même dans des cas où l'énergie transmise par le signal de commande ne serait pas suffisante pour provoquer un tel basculement.

Dans un tel mode de réalisation, l'énergie électrique apportée par de tels signaux de commande à faible énergie s'accumule au niveau de cet élément de stockage d'énergie jusqu'à ce que la tension aux bornes de cet élément de stockage d'énergie devienne supérieure à la valeur de tension pour laquelle les moyens de commande ouvre ou ferme l'interrupteur I (typiquement la valeur de tension nécessaire au basculement du relais 4 dans l'exemple de la figure 1).

Afin de discriminer le signal de commande des autres signaux reçus sur le port d'entrée du dispositif de l'invention, deux variantes de réalisation sont proposées:
- dans une première variante, on opère une discrimination en fréquence du signal de commande, au moyen d'un filtre passe-bande tel que décrit précédemment en relation avec les figures 1 à 4 par exemple;
- dans une deuxième variante, on opère une discrimination en tension du signal de commande. En d'autres termes, la charge de l'élément de stockage ne débute que lorsque la tension à ses bornes est supérieure à un seuil prédéterminé, ce seuil étant plus élevé que la tension des autres signaux présents sur le médium de transmission du signal de commande et reçus sur le port d'entrée.

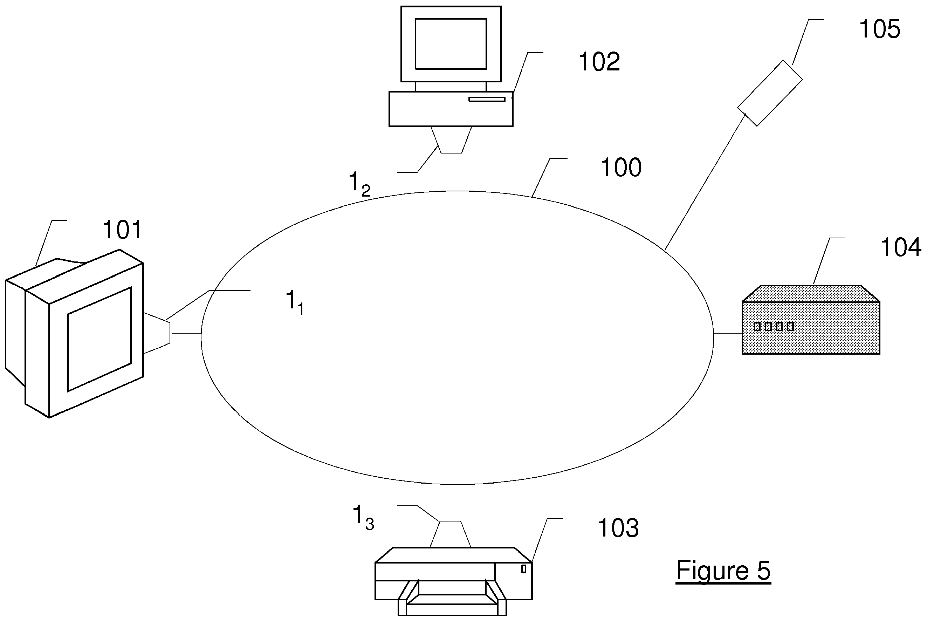

On présente désormais en relation avec la figure 5 un exemple de réseau électrique domestique 100, sur lequel sont connectés un téléviseur 101, un ordinateur 102 et une imprimante 103. Une passerelle de communication 104 de type Livebox (marque déposée) par exemple est également branchée sur ce réseau d'alimentation électrique 100. Chacun de ces équipements domestiques référencés 101 à 103 est connecté au réseau d'alimentation électrique 100 par l'intermédiaire d'un dispositif de commande conforme à l'invention référencé respectivement 1₁ à 1₃.

Un module central de commande 105 permet à l'utilisateur de ces équipements domestiques de les mettre tous hors connexion lorsqu'ils sont inutilisés pendant une longue période, la nuit par exemple. Ce module central de commande 105 envoie un signal de commande par l'intermédiaire du réseau électrique 100: ce signal de commande est reçu sur chacun des dispositifs de commande 1₁ à 1₃, où il est filtré et permet d'actionner un interrupteur associé. En mode déconnecté, l'ensemble de ces appareils a une consommation électrique nulle, contrairement aux modes de veille connus dans l'art antérieur.

Au moment opportun, le matin par exemple, le module central de commande 105 peut mettre tous les appareils sous tension, de façon programmée (à heure fixe par exemple), ou par intervention de l'utilisateur.

L'utilisateur peut également utiliser la télécommande centrale 105 pour mettre hors connexion l'un seulement des appareils de son réseau, tel que le téléviseur 101 par exemple, en émettant un signal de commande spécifique au dispositif de commande 1₁.

A titre de variante, le module central de commande peut être intégré dans le modem de communication 104: dans ce cas, c'est cette passerelle de communication 104 qui envoie les signaux de commande pour connecter ou déconnecter chacun des appareils électriques 101 à 103 du réseau.

Bien entendu, l'invention n'est pas limitée aux exemples de réalisation ci-dessus décrits et représentés, à partir desquels on pourra prévoir d'autres modes et d'autres formes de réalisation, sans pour autant sortir du cadre de l'invention, tel que défini par les revendications annexées.

## Revendications

1. Dispositif de commande d'au moins un interrupteur d'alimentation électrique (I), comprenant :
au moins un port d'entrée (2) apte à recevoir un signal de commande dudit au moins un interrupteur ;
des moyens de commande (4,5) comprenant au moins un relais (4) apte à actionner ledit au moins un interrupteur et au moins un filtre passe-bande passif (5), apte à opérer un filtrage en fréquence dudit signal de commande, ledit au moins un filtre passe-bande étant connecté audit au moins un relais, les moyens de commande étant électriquement passifs en l'absence de signal de commande et configurés pour être alimentés électriquement au moyen du signal de commande ; **caractérisé par**
un port de commande (6), distinct du port d'entrée (2), connecté audit au moins un relais (4) et apte à fournir aux bornes dudit relais (4) une tension adéquate injectée par un équipement local.

2. Dispositif de commande selon la revendication 1, **caractérisé en ce qu'**il comprend au moins deux filtres passe-bandes dont les bandes passantes sont centrées sur des fréquences distinctes.

3. Dispositif de commande selon l'une quelconque des revendications 1 et 2, **caractérisé en ce qu'**il comprend au moins deux relais, un premier relais apte à actionner l'ouverture dudit interrupteur et un deuxième relais apte à actionner la fermeture dudit interrupteur.

4. Dispositif de commande selon l'une quelconque des revendications 1 et 2, **caractérisé en ce qu'**il comprend au moins deux relais, un premier relais apte à actionner un premier interrupteur et un deuxième relais apte à actionner un deuxième interrupteur.

5. Dispositif de commande selon l'une quelconque des revendications 1 à 4, **caractérisé en ce que** ledit port d'entrée est une prise électrique mâle, **en ce que** ledit dispositif de commande comprend une prise électrique femelle connectée à ladite prise électrique mâle par au moins un fil de phase et au moins un fil de neutre, et **en ce que** ledit interrupteur est situé sur ledit au moins un fil de phase reliant ladite prise électrique mâle et ladite prise électrique femelle.

6. Dispositif selon l'une quelconque des revendications 1 à 5, **caractérisé en ce que** ledit port d'entrée est de type optique, et **en ce que** ledit filtre passe-bande est un filtre passe-bande optique passif.

7. Dispositif selon l'une quelconque des revendications 1 à 5, **caractérisé en ce que** ledit signal de commande est un signal radio et **en ce que** ledit dispositif comprend une antenne apte à recevoir ledit signal radio et à le transmettre audit port d'entrée.

8. Dispositif selon l'une quelconque des revendications 1 à 7, comprenant en outre un élément de stockage d'énergie inséré entre le port d'entrée et les moyens de commande.

9. Appareil électrique comprenant un dispositif de commande d'un interrupteur d'alimentation électrique selon l'une quelconque des revendications 1 à 8.

10. Appareil électrique selon la revendication 9, **caractérisé en ce que** ledit appareil est un modem à Courant Porteur en Ligne.

## Patentansprüche

1. Vorrichtung zum Steuern wenigstens eines Ein/Aus-Schalters (I) für die Stromversorgung, die Folgendes umfasst:
wenigstens einen Eingangsanschluss (2), der ein Steuersignal des wenigstens einen Ein/Aus-Schalters empfangen kann;
Steuermittel (4, 5), die wenigstens ein Relais (4), das den wenigstens einen Ein/Aus-Schalter betätigen kann, und wenigstens ein passives Bandpassfilter (5), das an dem Steuersignal eine Frequenzfilterung vornehmen kann, umfassen, wobei das wenigstens eine Bandpassfilter mit dem wenigstens einen Relais verbunden ist, wobei die Steuermittel bei Abwesenheit des Steuersignals elektrisch passiv sind und konfiguriert sind, mittels des Steuersignals elektrisch versorgt zu werden, **dadurch gekennzeichnet, dass** ein Steueranschluss (6), der von dem Eingangsanschluss (2) verschieden ist und mit dem wenigstens einen Relais (4) verbunden ist, an die Anschlüsse des Relais (4) eine geeignete Spannung liefern kann, die durch eine lokale Ausrüstung injiziert wird.

2. Steuervorrichtung nach Anspruch 1, **dadurch gekennzeichnet, dass** sie wenigstens zwei Bandpassfilter umfasst, deren Durchlassbänder auf unterschiedliche Frequenzen zentriert sind.

3. Steuervorrichtung nach einem der Ansprüche 1 und 2, **dadurch gekennzeichnet, dass** sie wenigstens zwei Relais umfasst, wobei ein erstes Relais das Öffnen des Ein/Aus-Schalters betätigen kann und ein zweites Relais das Schließen des Ein/Aus-Schalters betätigen kann.

4. Steuervorrichtung nach einem der Ansprüche 1 und 2, **dadurch gekennzeichnet, dass** sie wenigstens zwei Relais umfasst, wobei ein erstes Relais einen ersten Ein/Aus-Schalter betätigen kann und ein zweites Relais einen zweiten Ein/Aus-Schalter betätigen kann.

5. Steuervorrichtung nach einem der Ansprüche 1 bis 4, **dadurch gekennzeichnet, dass** der Eingangsanschluss ein elektrischer Stecker ist, dass die Steuervorrichtung eine elektrische Buchse umfasst, die mit dem elektrischen Stecker durch wenigstens einen Phasenleiter und wenigstens einen Neutralleiter verbunden ist, und dass sich der Ein/Aus-Schalter in dem wenigstens einen Phasenleiter befindet, der den elektrischen Stecker mit der elektrischen Buchse verbindet.

6. Vorrichtung nach einem der Ansprüche 1 bis 5, **dadurch gekennzeichnet, dass** der Eingangsanschluss vom optischen Typ ist und dass das Bandpassfilter ein passives optisches Bandpassfilter ist.

7. Vorrichtung nach einem der Ansprüche 1 bis 5, **dadurch gekennzeichnet, dass** das Steuersignal ein Funksignal ist und dass die Vorrichtung eine Antenne enthält, die das Funksignal empfangen und es an den Eingangsanschluss übertragen kann.

8. Vorrichtung nach einem der Ansprüche 1 bis 7, die außerdem ein Energiespeicherelement umfasst, das zwischen dem Eingangsanschluss und den Steuermitteln eingefügt ist.

9. Elektrogerät, das eine Vorrichtung zum Steuern eines Ein/Aus-Schalters für die Stromversorgung nach einem der Ansprüche 1 bis 8 umfasst.

10. Elektrogerät nach Anspruch 9, **dadurch gekennzeichnet, dass** das Gerät ein Trägerstromanlagen-Modem ist.

## Claims

1. Device for controlling at least one electrical power supply switch (I), comprising:
at least one input port (2) able to receive a control signal of said at least one switch;
control means (4, 5) comprising at least one relay (4) able to actuate said at least one switch, and at least one passive bandpass filter (5), able to operate a frequency filtering of said control signal, said at least one bandpass filter being connected to said at least one relay, the control means being electrically passive in the absence of any control signal and configured to be supplied electrically by means of the control signal; **characterized by** a control port (6), distinct from the input port (2), connected to said at least one relay (4) and able to provide across the terminals of said relay (4) a suitable voltage injected by a local piece of equipment.

2. Control device according to Claim 1, **characterized in that** it comprises at least two bandpass filters whose passbands are centered on distinct frequencies.

3. Control device according to either one of Claims 1 and 2, **characterized in that** it comprises at least two relays, a first relay able to actuate the opening of said switch and a second relay able to actuate the closing of said switch.

4. Control device according to either one of Claims 1 and 2, **characterized in that** it comprises at least two relays, a first relay able to actuate a first switch and a second relay able to actuate a second switch.

5. Control device according to any one of Claims 1 to 4, **characterized in that** said input port is a male electrical contact, **in that** said control device comprises a female electrical contact connected to said male electrical contact by at least one phase wire and at least one neutral wire, and **in that** said switch is situated on said at least one phase wire linking said male electrical contact and said female electrical contact.

6. Device according to any one of Claims 1 to 5, **characterized in that** said input port is of optical type, and **in that** said bandpass filter is a passive optical bandpass filter.

7. Device according to any one of Claims 1 to 5, **characterized in that** said control signal is a radio signal and **in that** said device comprises an antenna able to receive said radio signal and to transmit it to said input port.

8. Device according to any one of Claims 1 to 7, furthermore comprising an energy storage element inserted between the input port and the control means.

9. Electrical apparatus comprising a device for controlling an electrical power supply switch according to any one of Claims 1 to 8.

10. Electrical apparatus according to Claim 9, **characterized in that** said apparatus is a Power Line Communications modem.
